Europäisches Patentamt

(19) European Patent Office

Office européen des brevets

(11) Veröffentlichungsnummer: **0 218 613**
**B1**

(12) # EUROPÄISCHE PATENTSCHRIFT

(45) Veröffentlichungstag der Patentschrifft:
**17.01.90**

(51) Int. Cl. ⁴: **G 03 B 41/00**

(21) Anmeldenummer: **86901820.0**

(22) Anmeldetag: **27.03.86**

(86) Internationale Anmeldenummer:
**PCT/DE 86/00131**

(87) Internationale Veröffentlichungsnummer:
**WO 86/05895 (09.10.86 Gazette 86/22)**

(54) ANORDNUNG ZUR AUSRICHTUNG, PRÜFUNG UND/ODER VERMESSUNG ZWEIDIMENSIONALER OBJEKTE.

(30) Priorität: **06.04.85 DE 3512615**

(43) Veröffentlichungstag der Anmeldung:
**22.04.87 Patentblatt 87/17**

(45) Bekanntmachung des Hinweises auf die Patenterteilung:
**17.01.90 Patentblatt 90/03**

(84) Bennante Vertragsstaaten:
**DE FR GB NL**

(56) Entgegenhaltungen:
**DE-A-3 305 014**
**GB-A-1 477 625**
**US-A-3 542 476**
**US-A-3 865 483**
**US-A-4 165 149**
**US-A-4 251 160**
**US-A-4 266 876**

(73) Patentinhaber: **Wild Leitz GmbH**
**Ernst-Leitz-Strasse 30 Postfach 20 20**
**D-6330 Wetzlar 1 (DE)**

(72) Erfinder: **SCHUSTER, Erich**
**Friedrichstrasse 10**
**D-6338 Hüttenberg (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

2

**Beschreibung**

Die Erfindung betrifft eine Anordnung zur Ausrichtung, Prüfung und/oder Vermessung zweidimensionaler Objekte, die sich auf einem wenigstens in zwei senkrecht zueinander verlaufenden Koordinatenrichtungen verschiebbaren Tisch einer Meßmaschine befinden und deren koordinatenmäßige Lage durch Antastung mittels eines Lichtflecks je Koordinatenrichtung ermittelt wird.

Mit Anordnungen dieser Art werden die Strukturen von Masken oder Wafern erfaßt, aus gerichtet, geprüft und/oder vermessen.

Aus der DE-OS-3 305 014 ist ein Verfahren mit Anordnung zur Ermittlung von Überdeckungsfehlern an Meßmarken oder Mikrostrukturen bekannt, mit welchem die Maßhaltigkeit von Werkstücken aus dem Bereich der Halbleitertechnik fotoelektrisch überprüft wird. Dies geschieht unter Verwendung eines optischen Bildkomparators mit zwei Bildkanälen, die mit Licht unterschiedlicher Wellenlänge beleuchtet werden und mit denen ein überlagertes Bild erzeugt wird. Dieses wird in die Ebene eines Meßspaltes übertragen und relativ zu diesem bewegt. Das durch den Meßspalt hindurchtretende Licht wird mittels eines Selektivspiegels in Lichtenergieanteile jeweils einer bestimmten Wellenlänge zerlegt und über Bandpaßfilter Strahlungsempfängern zugeführt, an die eine Auswerteeinheit zur Ermittlung der Überdeckungsfehler angeschlossen ist.

Meßanordnungen mit zweikanaligem Bildkomparator sind aber vom Aufbau her aufwendig in jeder Beziehung und nicht für Absolutmessungen geeignet.

Aus US-A-4 266 876 ist ein automatischer Alignment-Apparat bekannt, der geeignet ist, zwei übereinanderliegende Objekte mit speziell ausgebildeten Referenzmarken in die vorbestimmte Relativlage zu bringen. Dazu wird ein Laserlichtstrahl über die Objekte gescannt. Vom Laser gelangt das Licht auf einem rotierenden Polygonspiegel, danach wird es in zwei Teile aufgeteilt, welche die Referenzmarken zu verschiedenen Zeiten in verschiedenen Richtungen scannen. Zum Nachweis dienen Fotodetektoren neben dem Scan-Objektiv, eine Abbildung der Objekte ist nicht vorgesehen. Die Lage des Polygonspiegels wird nicht erfaßt, damit ist eine Messung von Positionen auf den Objekten unmöglich. In einer ersten Variante verursacht ein Chopper, wie angegeben, Lichtverluste und mechanische Erschütterungen. Für eine zweite Variante wird ein erhöhter optischer Aufwand bei eingeschränkter Scanweite angegeben.

Es ist Aufgabe der Erfindung, eine vielseitige gattungsgemäße Anordnung anzugeben, die besonders für Absolutmessungen geeignet ist und bei einfachem Aufbau störungsfrei und präzise ist.

Für eine Anordnung der eingangs genannten Art gelingt die Lösung der Aufgabe durch Einführung der kennzeichnenden Merkmale des Anspruchs 1 oder des Anspruchs 2.

Weitere vorteilhafte Ausbildungen der Erfindung sind Gegenstand der Unteransprüche.

Grundidee ist es, zwei mit unterschiedlicher physikalische Kennung versehene Lichtflüsse in einem Strahlengang zu vereinigen, innerhalb des vereinigten Strahlengangs ein Ablenkelement, das nur in einer Achse beweglich ist, vorzusehen und anschließend mit stationären optischen Mitteln eine Aufspaltung in zwei Strahlengänge mit unterschiedlicher Scanrichtung unter Ausnutzung der unterschiedlichen Kennung zu erzeugen.

In der Zeichnung ist die Erfindung in Ausführungsbeispielen schematisch dargestellt und im folgenen näher beschrieben. Es zeigen:

Fig. 1 eine erfindungsgemäße mit Auflicht arbeitende Einrichtung mit je Koordinatenrichtung einer Beleuchtungseinrichtung,

Fig. 2 eine neue, erweiterte Einrichtung zur Verwendung als mit Auflicht arbeitendes Vergleichsgerät,

Fig. 3 die neue Einrichtung in Kombination mit einem Referenz und Hohlspiegel zur Prüfung der Planität von Spiegelflächen und zur Ermittlung der Ebenheit der im Gerät eingebauten Spiegel und

Fig. 4 schematisch einen 2-Koordinaten-Meßtisch mit Referenz- und Hohlspiegel in Draufsicht.

Bei der Vermessung von Masken oder Wafern wird in bekannter Weise das Bild einer Laser-Diode über die auszurichtende, zu prüfende oder zu vermessende Struktur geführt. Es wird die Kantenfunktion aufgenommen, aus welcher die exakte Kantenlage ermittelt wird.

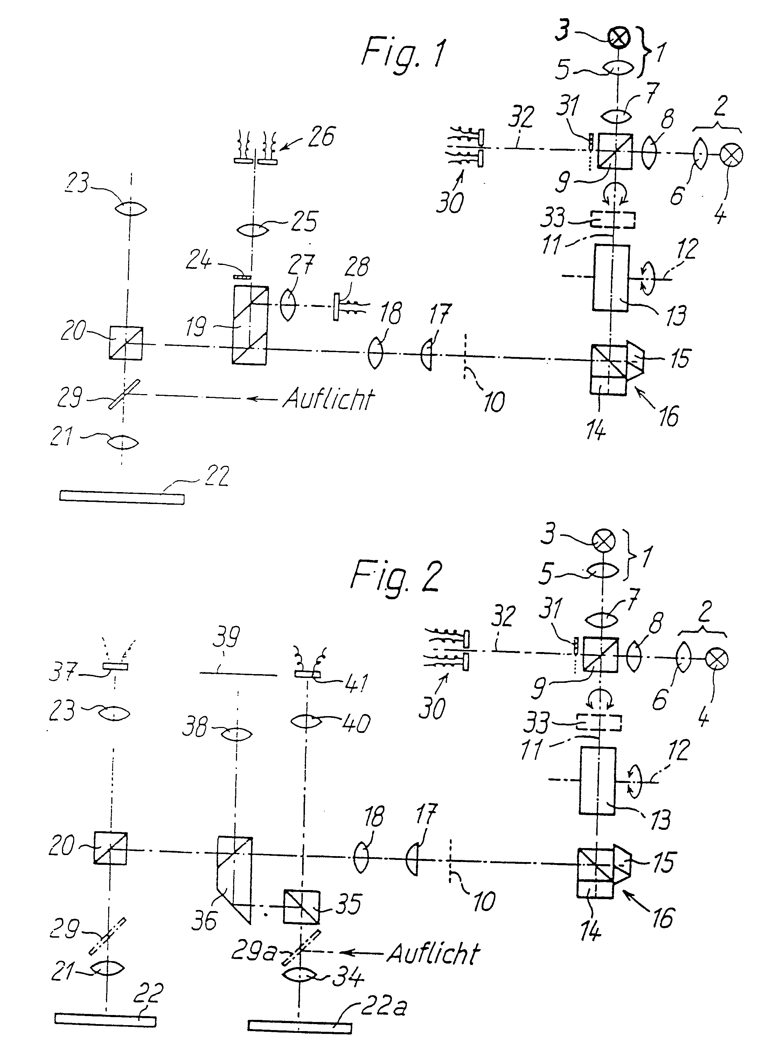

Bei der in Fig. 1 dargestellten neuen Einrichtung sind pro x- bzw. y-Koordinatenrichtung eine beispielsweise kollimiertes Licht aussendende Beleuchtungseinrichtung 1 bzw. 2 vorgesehen. Diese Beleuchtungseinrichtungen bestehen je aus einer Laserdiode 3 bzw. 4 und einem Objektiv 5 bzw. 6.

Eine Tubuslinse 7 bzw. 8 je Koordinatenrichtung gebildet über einen Strahlenteilerwürfel 9 aus den Lichtflüssen der Beleuchtungseinrichtungen 1,2 einen Lichtfleck in die Zwischenbildebene 10 ab. In den Abbildungsweg zwischen Strahlenteilerwürfel 9 und Zwischenbildebene 10 ist eine um eine zur optischen Achse 11 der Einrichtung senkrechte Achse 12 schwenkbare Planparallelplatte 13 angeordnet, mittels welcher der in der Zwischenbildebene 10 entstehende Lichtpunkt senkrecht zur optischen Achse 11 verlagert wird. Die Schwenkbewegung der Planparallelplatte 13 wird von einem hier nicht mit dargestellten Winkelschrittgeber erfaßt. Der elektrische Wert der Schwenkbewegungsgröße wird in einem Speicher eines hier ebenfalls nicht gezeigten Rechners festgehalten.

Für den Fachmann versteht es sich, daß ganz allgemein anstelle der Planparallelplatte 13 ein Schwenkspiegel oder eine Schiebelinse verwendet sein kann, mittels welchen die aus den Beleuchtungseinrichtungen 1, 2 erzeugten Lichtflecke senkrecht zur optischen Achse versetzt

2

werden können. Bei Verwendung einer Schiebelinse tritt dann an die Stelle des die Bewegung erfassenden Winkelschrittgebers ein ebenso hoch auflösender Lägenschrittgeber.

Zur Kennung der beiden Meßrichtungen im gemeinsamen Strahlengang erzeugt die Teilerfläche des Strahlenteilerwürfels 9 aus dem von den Beleuchtungseinrichtungen 1, 2 abgegebenen monochromatischen Licht eine polarisierte Strahlung, deren Schwingungsrichtungen um 90° gegeneinander verdreht sind.

Die Teilerfläche der Prismenkombination 16 wirkt als Analysator und lenkt die beiden Teilstrahlengänge je nach ihrer Schwingungsrichtung in das Prisma 14 bzw. 15. Zwischen dem eigentlichen Teilerprisma und den Prismen 14 bzw. 15 sind doppelbrechende Mittel vorgesehen, die bei zweimaligem Durchtritt die Schwingungsrichtung des Lichtes um 90° drehen, so daß die beiden Lichtflüsse in Richtung Zwischenbildebene 10 austreten können.

Die Dachkante des Prismas 15 ist um 45° gegenüber der Zeichenebene versetzt. Diese Form des Teilerprismas 16 bewirkt eine Auslenkung der durch den Strahlenteilerwürfel 9 im Strahlen-gang zusammengeführten, aus den Beleuch-tungseinrichtungen 1, 2 herrührenden Lichtflüsse in die ihnen zugeordneten Koordinatenrichtungen. Das heißt, dass in der Zwischenbildebene 10 zwei um 90° gegeneinander verdrehte Bilder der Lichtflecken entstehen, die bei Verschwenken der Planparallelplatte 13 in Richtung der ihnen zugeordneten Koordinate auswandern.

Die Reflexionsfläche des Prismas 14 kann als Dachkante oder ebene Spiegelfläche ausgeführt sein.

In Richtung des von den Laserdioden 3, 4 ausgestrahlten Lichtes gesehen, befindet sich hinter der Zwischenbildebene 10 eine Feldlinse 17, die zusammen mit einer weiteren Tubuslinse 18 die Austrittspupillen der Objektive 5, 6 über einen mit zwei Teilerflächen versehenen Lichtteiler 19 und einem Teilerwürfel 20 geringfügig verkleinert in der Eintrittspupille eines abbildenden Systems 21 abbildet. Dieses projiziert dann den der jeweiligen Koordinatenrichtung zugeordneten Lichtfleck auf das nicht mit gezeigte, auf einem Tisch 22 einer Meßmaschine befindliche Meß- oder Prüfobjekt.

Durch die Verkleinerung wird erreicht, daß beim Verschwenken der Planparallelplatte 13 - welches auch einen dem Verschwenkweg entsprechenden Versatz der Pupillenbilder bewirkt - keine Vignettierung des Strahlenbündels in der Eintrittspupille des abbildenden Systems 21 verursacht wird.

Der vom Objekt reflektierte Lichtfluß wird vom Teilerwürfel 20, dessen Teilerschicht der besse-ren Lichtausbeute wegen vorzugsweise dichro-matische Eigenschaften besitzen soll, in zwei Teillichtflüsse getrennt, von denen der eine über eine Linse 23 einem visuellen Einblick zugeführt wird. Es ist auch möglich, daß an die Stelle des Einblicks eine TV- oder eine CCD-Kamera montiert ist.

Der andere Lichtflußanteil wird von der Teilerschicht des Teilerwürfels 20 zum Lichtteiler 19 zurückgelenkt, dessen erste Teilerschicht den Lichtflußanteil über eine Blende 24 und eine Sammellinse 25 einem Differenzfotoempfänger 26 zuführt, dessen Ausgangssignale automatisch die Fokussierung des abbildenden Systems 21 auf das Objekt regeln.

Die zweite Teilerschicht des Lichtteilers 19 lenkt einen anderen Teil des Lichtflußanteils über eine Sammellinse 27 zu einem fotoelektrischen Empfänger 28, dessen Aufgabe weiter unten noch beschrieben wird.

Zwischen dem Teilerwürfel 20 und dem abbildenden System 21 ist ein teildurchlässiger Spiegel 29 angeordnet, welcher bei visueller oder TV-Beobachtung der Einspiegelung von Licht aus einer hier nicht mit dargestellten Auflichtbeleuchtungseinrichtung dient.

Die Messung in einer der Koordinatenrichtungen wird folgendermaßen durchgeführt:

Bei Einschaltung der Beleuchtungseinrichtung 1 entwirft deren Objektiv 5 aus dem Lichtfluß der Laserdiode 3 einen Lichtfleck im Unendlichen. Die Tubuslinse 7 übernimmt diesen Lichtfleck zur Abbildung in der Zwischenbildebene 10. Er wird dabei über die schwenkbare Planparallelplatte 13 sowie durch das Teilerprisma 16 geführt und gelangt über die Feldlinse 17, die Tubuslinse 18, die Teiler 19, 20 und das abbildende System 21 zur Abbildung auf das nicht dargestellte Objekt auf dem Tisch 22 der Meßmaschine.

Wie bereits oben geschildert bewirkt die Schwenkbewegung der Planparallelplatte 13 und das Teilerprisma 16, daß der Lichtfleck senkrecht zur optischen Achse in der jeweiligen Koordinatenrichtung über die anzutastenden Strukturen des Objekts geführt wird. Der vom Objekt reflektierte, durch die Antastung die Kantenfunktion der Objektstrukturen beinhaltende Lichtfluß wird, wie oben geschildert, dem fotoelektrischen Empfänger 28 zugeführt und von diesem in elektrische Signale umgesetzt. Diese werden in einem Rechner gespeichert und dienen in Abhängigkeit von der Winkelstellung der Planparallelplatte 13 nach Berechnung der Ausgleichsgeraden zur Ermittlung der Kantenlage.

Für die Messung in der anderen Koordinatenrichtung wird in analoger Weise verfahren. Nur wird dazu die Beleuchtungseinrichtung 2 eingeschaltet, und der Lichtfleck durchläuft auf seinem Weg zum Objekt im Teilerprisma 16 einen anderen Pfad, nämlich den über das Dachkantprisma 15, der eine Auslenkung in einer um 90° versetzten Richtung gegenüber der Auslenkung des anderen Lichtflecks bewirkt.

Die weiter oben beschriebene automatische Fokussierung des abbildenden Systems 21 (Scharfabbildung des Lichtflecks) auf das Objekt ist eine wichtige Voraussetzung für die Genauigkeit der Messung. Sie muß deshalb sehr exakt sein. Die im vom Lichtteiler 19 abgeleiteten "Au-tofokus"-Strahlengang befindliche Blende 24 ist daher so ausgebildet, daß sie die eine Hälfte des Strahlenganges abdeckt. Bei Scharfeinstellung des abbildenden Systems 21 auf das Objekt (= Scharfabbildung des Lichtflecks auf dem Objekt) wird das Bild des Lichtflecks stets auf den Trennspalt des Differenzfotoempfängers 26 fallen, der seinerseits dann durch Abgabe eines "O"-Signals die Scharfeinstellung signalisiert.

Es versteht sich, daß die durch die Planparallelplatte 13 erzeugte Abtastbewegung parallel zum Trennspalt 24 des Differenzfotoempfängers 26 verlaufen muß. Ist dies nicht der Fall, so wird eine Einrichtung erforderlich, welche die Planparallelplatte 13 in ihrer "O"-Stellung fixiert bzw. ein gleichmäßiges Schwingen um ihren "O"-Punkt sicherstellt.

Soll sowohl in der x- als auch in der y-Koordinatenrichtung fokussiert werden, wird der Differenzfotoempfänger 26 zweckmäßigerweise ein 4-Quadrantenempfänger sein, bei dem, je nach Schwingungsrichtung des Lichtflecks, jeweils zwei Empfängerflächen zusammengeschaltet sind.

Beim Fokussieren werden die Laserdioden 3, 4 der Beleuchtungseinrichtung 1, 2 zweckmäßigerweise gepulst, damit von der normalen Objektbeleuchtung herrührende Gleichlichtflüsse eliminiert werden können.

Durch Erwärmung der Laserdioden sind sowohl axiale als auch radiale Verlagerungen der Lichtflecken möglich. Radiales Driften während einer Messung führt zu Meßfehler, axiales Driften zu Vergrößerungsänderungen, die insbesondere in den Endbereichen der Abtastbewegung Meßfehler hervorrufen. Eine Überwachung des "Standes" der Laserdioden 3, 4 ist daher erforderlich. Sie erfolgt durch einen Differenzfotoempfänger 30 in Verbindung mit einer auf Umschlag umschaltbaren Blende 31, die in einem vom Strahlenteilerwürfel 9 abgezweigten Strahlengang 32 angeordnet sind.

Bei axialer wie auch bei radialer Verschiebung einer der Laserdioden 3, 4 wird eine Empfängerfläche des Differenzfotoempfängers 30 stärker bestrahlt als die andere. Bei radialer Dezentrierung der Laserdioden 3, 4 in Meßrichtung ändert sich bei Umschlagen der Blende 31 die Bestrahlung der Empfängerflächen nicht. Bei axialer Verschiebung und Umschalten der Blende 31 jedoch wechselt die stärkere bzw. schwächere Bestrahlung von der einen zur anderen Fläche.

Zur Korrektur der Vergrößerungsänderung (Fokus) kann sowohl das Objektiv 5, 6 als auch die Tubuslinse 7, 8 in axialer Richtung verstellt werden. Es ist jedoch vorteilhafter, die Tubuslinsen 7, 8 zu verstellen, anstatt die Objektive 5, 6. Es ergeben sich nämlich hier mit dem Quadrat der Vergrößerung größere Verstellwege, die geringere Anforderungen an die Verstellmittel stellen. Auch die Anforderungen an die Geradführung sind hier wesentlich geringer.

Weitgehend ausschalten kann man die Einflüsse des "Lichtfleck-Driftens" durch Verwendung von Lichtleitern, über welche die Strahlungsenergie der Laserdioden den Beleuchtungseinrichtungen zugeführt wird.

Zur Verlagerung der Lichtflecke senkrecht zur jeweiligen Koordinatenrichtung kann zusätzlich eine weitere Planparallelplatte 33 vorgesehen sein, deren Schwenkachse senkrecht zur Schwenkachse 12 der Planparallelplatte 13 steht.

Ist vorgesehen, die Verlagerung der Lichtflecken unabhängig voneinander vorzunehmen, kann jeweils pro Koordinatenrichtung eine schwenkbare Planparallelplatte 33 auch vor dem Strahlenteiler 9 angeordnet sein.

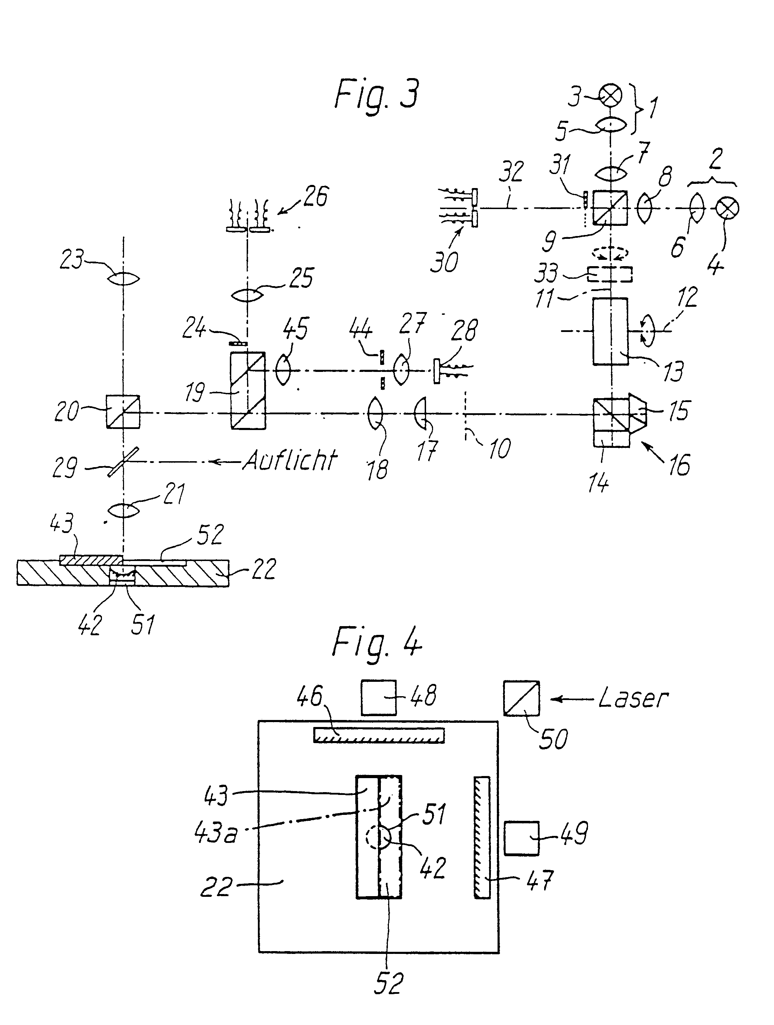

Die neue Anordnung zur Ausrichtung, Prüfung und/oder Vermessung zweidimensionaler Objekte kann in leichter Abänderung auch als Maskenvergleichsgerät Verwendung finden. Ein Beispiel für eine solche modifizierte Einrichtung zeigt die Fig. 2, in welcher die mit der Fig. 1 gleichen Bauteile mit gleichem Bezugszeichen versehen sind.

Um eine auf dem Meßtisch 22 liegende, nicht näher gekennzeichnete "Arbeitsmaske" mit einer "Meistermaske" vergleichen zu können, wird diese Anordnung um ein weiteres abbildendes System 34, 40 sowie um einen Trennwürfel 35 und ein Mischerprisma 36 erweitert.

Geht man davon aus, daß mit dem abbildenden System 21 die Arbeitsmaske und mit dem abbildenden System 34 die Meistermaske betrachtet wird, arbeitet die neue Anordnung wie folgt:

Wie zu Fig. 1 beschrieben, werden die je Koordinatenrichtung in der Zwischenbildebene 10 erzeugten Lichtflecken von den Linsen 17, 18 übernommen und zum einen über das Mischerprisma 36, den Trennwürfel 35 und das abbildende System 34 auf die Meistermaske und zum anderen nach Durchsetzen des Mischerprismas 36 über den Teilerwürfel 20 und das abbildende System 21 auf die Arbeitsmaske projiziert.

Der von der Arbeitsmaske projizierte Lichtfluß wird einmal über den Teilerwürfel 20 und die Linse 23 einem fotoelektrischen Empfänger 3 zugeführt. Dort wird die Kantenfunktion gebildet.

Der von der Meistermaske ausgehende Lichtfluß wird über das abbildende System 34 den Trennwürfel 3 und eine Optik 40 auf einen fotoelektrischen Empfänger 41 geleitet. Dort wird die Kantenfunktion der Meistermaske gebildet.

Der Abstand zwischen der Kantenlage der Meistermaske und der Kantenlage der Arbeitsmaske wird durch Differenzbildung aus den zugehörigen Werten aus dem mit der planparallelen Platte 13 gekoppelten Winkelschrittgeber ermittelt.

Zur visuellen oder zur TV-Beobachtung wird der von der Arbeitsmaske reflektierte Lichtfluß über den Teilerwürfel 20 auch zum Mischerprisma 36 und von diesem nach Durchsetzen einer Anpassungsoptik 38 in eine Ebene 39 gelenkt, in welcher die Fotokathode einer TV-Kamera (nicht mit dargestellt) angeordnet ist.

Zur Beobachtung des gesamten Sehfeldes wird eine in Fig. 2 gestrichelt dargestellte Auflichtbeleuchtung eingesetzt, die in ihrer Helligkeit so bemessen ist, daß sowohl die gesamte Maske als auch der Antast-Lichtfleck betrachtet werden können. Es ist aber auch denkbar, daß eine

7

Durchlicht-Beleuchtungseinrichtung verwendet wird.

Die neue Anordnung kann aber auch bei geringfügiger Erweiterung, nämlich um einen Hohlspiegel 42, einen Referenzspiegel 43 und eine vor die Sammellinse 27 und den fotoelektrischen Empfänger 28 zu schaltende Kombination aus Blende 44 und Tubuslinse 45, zum Antasten von Meßflächen dienen, welche zur optischen Achse der Anordnung parallel liegen. Auch die Ebenheit der Planspiegel von 2-Koordinaten-Meßmaschinen mit Laser-Interferometern kann dann im eingebauten Zustand mit einer solchen Anordnung in hoher Genauigkeit ermittelt werden.

Ein mögliches Ausführungsbeispiel für eine solch erweiterte Anordnung zeigen die Fig. 3 und 4. In der letzteren ist der Einfachheit halber je ein Planspiegel 46, 47 pro Koordinatenrichtung auf dem Tisch 22 der Meßmaschine angeordnet gezeigt. Sie wirken mit Interferometern 48, 49 zusammen, die über ein Scheideprisma 50 die Strahlung eines Lasers (nicht dargestellt) erhalten.

Zur Überprüfung der Ebenheit der Planspiegel 46, 47 ist der Hohlspiegel 42 so angeordnet, daß sein Krümmungsmittelpunkt in der Schärfenebene des abbildenden Systems 21 liegt. Dazu ist der Tisch 22 mit einer Aussparung 51 versehen, in welche der Hohlspiegel 42 eintauchen kann.

Soll nun die Ebenheit des Spiegels 47 in der x-Koordinatenrichtung ermittelt werden, so muß der Referenzspiegel 43 parallel zum Spiegel 47, wie mit den durchgehenden Linien in Fig. 4 angedeutet, angeordnet werden.

Außerdem ist der Referenzspiegel 43 so auf den Tisch 22 aufzulegen, daß seine Mitte mit der Tischebene bündig abschließt. Dafür ist der Tisch 22 neben der Ausnehmung 49 mit einer weiteren Ausnehmung 52 versehen. Die Tiefe dieser Ausnehmung ist derart bemessen, daß die oben gestellte Bedingung erfüllt wird.

In Verbindung mit der neuen Anordnung und dem Laser-Interferometer 48 werden nun die Abstände zwischen den Flächen der Spiegel (43, 47) in Abhängigkeit von der Stellung des Tisches 22 in der y-Koordinatenrichtung festgestellt. Die vom fotoelektrischen Empfänger 28 und dem mit der schwingenden Planparallelplatte 13 gekoppelten Schrittgeber ermittelten Kantenlagen werden mit den dazugehörigen Meßwerten des Laser-Interferometers 48 verknüpft. Aus den Einzelwerten wird eine Fehlerkurve in Abhängigkeit von der Stellung des Meßtisches 22 in der x-Koordinatenrichtung ermittelt.

Anschließend wird der Referenzspiegel 43 um eine zur y-Koordinatenrichtung parallele Achse um 180° in die in Fig. 4 gestrichelt dargestellte Lage verbracht und erneut die Fehlerkurve, wie zuvor beschrieben, ermittelt.

Durch Mittelwertbildung aus den Meßwertpaaren und durch mathematische Elimination der Ausrichtfehler (Parallelitätsabweichung zwischen Spiegel 43 bzw. 43a und 47) erhält man die Ebenheitsabweichung des Spiegels 47 in Abhängigkeit der Stellung des Tisches 22 in der y-

8

Koordinatenrichtung.

Bei diesen Messungen wird die Blende 44 als Referenzkante eingesetzt. Sie wird deshalb zweckmäßigerweise als lichtundurchlässiger Strich ausgeführt, dessen Breite an die des Laser-Lichtflecks angepaßt ist. Sie kann jedoch auch als lichtundurchlässige Fläche ausgebildet sein, die etwa die Hälfte des Schwingbereiches des Laser-Lichtflecks abdeckt.

Wird als Strahlungsquelle eine Laser-Diode mit rechteckiger Leuchtfläche verwendet, so muß zur Erzielung einer ausreichenden Steilheit des daraus abgeleiteten Kantensignals, die Kante der Blende 44 senkrecht zur Schwingrichtung des Laser-Lichtflecks stehen. Sie muß also bei Wechsel der Meßrichtung x bzw. y gedreht werden.

Bei einer quadratischen oder kreisrunden Leuchtfläche kann die Blende 44 unter 45° zur Schwingrichtung fest orientiert angeordnet sein.

## Patentansprüche

1. Anordnung zur Ausrichtung, Prüfung und/oder Vermessung zweidimensionaler, auf einem wenigstens in zwei senkrecht zueinander verlaufenden Koordinatenrichtungen verschiebbaren Tisch (22) einer Meßmaschine befindlicher Objekte und Ermittlung ihrer koordinatenmäßigen Lage durch Antastung mittels eines Lichtflecks je Koordinatenrichtung, gekennzeichnet durch

(a) je Koordinatenrichtung eine aus einer Strahlungsquelle (3, 4) mit einem optischen Element bestehenden Belichtungseinrichtung (1, 2) mit mindestens einem strahlungssammelnden System (7,8) zur Fokussierung der Lichtflüsse und mit optischen Mitteln (9) zum Zusammenführen der beiden Lichtflüsse zu einem gemeinsamen Strahlengang (11) und Abbildung der Strahlungsquellen (3, 4) in einer gemeinsamen Zwischenebene (10), wobei gleichzeitig beide Lichtflüsse mit einer bestimmten Kennung versehen werden;

(b) ein in seiner Lage nur in einer Richtung veränderbares optisches Bauteil (13) zur Verlagerung der das Objekt abtastenden Lichtflecken entlang der ihnen jeweils zugeordneten Meß-Koordinatenrichtung;

(c) ein mit diesem Bauteil (13) gekoppeltes, an sich bekanntes Meßsystem zur Erfassung der jeweiligen Verlagerung;

(d) ein strahlenteilendes optisches Glied (16) zur Auslenkung der Lichtflüsse entsprechend ihrer Kennung, wobei die Abbildung einer der Strahlungsquellen, entsprechend der ihr zugeordneten Koordinatenrichtung mittels eines Dachkantprismas (15) um 90° gedreht wird;

(e) ein abbildendes System (21) zur Abbildung der beiden erzeugten Lichtquellenbilder auf das jeweilige Objekt und durch

(f) wenigstens ein fotoelektrisches Empfängersystem (28), welches vom jeweiligen Objekt reflektierte, aus der Antastung desselben resultierende Lichtflüsse in elektrische Meßsignale umsetzt.

2. Anordnung zur Ausrichtung, Prüfung und/oder Vermessung zweidimensionaler, auf einem wenigstens in zwei senkrecht zueinander verlaufenden Koordinatenrichtungen verschiebbaren Tisch (22) einer Meßmaschine befindlicher Objekte und Ermittlung ihrer koordinatenmäßigen Lage durch Antastung mittels eines Lichtflecks je Koordinatenrichtung, gekennzeichnet durch

(a) eine polarisierte Strahlungsquelle mit einer Beleuchtungseinrichtung mit nachgeschalteter Kerrzelle, mittels welcher die Polarisationsrichtung des Lichtes zur Kennung entsprechend den Koordinatenachsen verändert wird, mit mindestens einem strahlungssammelnden System zur Abbildung der Strahlungsquelle in einer Zwischenebene (10);

(b) ein in seiner Lage nur in einer Richtung veränderbares optisches Bauteil (13) zur Verlagerung der das Objekt abtastenden Lichtflecken entlang der ihnen jeweils zugeordneten Meß-Koordintenrichtung;

(c) ein mit diesem Bauteil (13) gekoppeltes, an sich bekanntes Meßsystem zur Erfassung der jeweiligen Verlagerung;

(d) ein strahlenteilendes optisches Glied (16) zur Auslenkung des Lichtes entsprechend der Kennung, wobei die Abbildung der Strahlungsquelle für eine Polarisationsrichtung entsprechend der ihr zugeordneten Koordinatenrichtung mittels eines Dachkantprismas (15) um 90° gedreht wird;

(e) ein abbildendes System (21) zur Abbildung der beiden erzeugten Lichtquellenbilder auf das jeweilige Objekt und durch

(f) wenigstens ein fotoelektrisches Empfängersystem (28), welches vom jeweiligen Objekt reflektiertes, aus der Antastung desselben resultierendes Licht in elektrische Meßsignale umsetzt.

3. Anordnung nach Anspruch 1 oder 2, dadurch gekennzeichnet, daß dem abbildenden System (21) fotoelektrische Wandlerelemente (26) zugeordnet sind, deren Ausgangssignale in bekannter Weise zu Steuersignalen verarbeitet eine ständige Scharfeinstellung des abbildenden Systems (21) auf das Objekt gewährleisten.

4. Anordnung nach Anspruch 1 oder 2, dadurch gekennzeichnet, daß optische Mittel (23, 37) vorgesehen sind, welche eine visuelle und/oder TV-Beobachtung des Objektes und/oder der Lichtflecke gestatten.

5. Anordnung nach Anspruch 1, dadurch gekennzeichnet, daß die die Lichtflüsse kennzeichnenden Mittel unterschiedlich polarisierte Lichtflüsse erzeugen.

6. Anordnung nach den Ansprüchen 1 oder 2, dadurch gekennzeichnet, daß an sich bekannte monochromatische Strahlungsquellen (3, 4) vorgesehen sind.

7. Anordnung nach Anspruch 1 oder 2, dadurch gekennzeichnet, daß in an sich bekannter Weise die Beleuchtungseinrichtung (1, 2) zur Erzeugung kollimierter Lichtflüsse ausgelegt ist.

8. Anordnung nach den Ansprüchen 1 oder 2, dadurch gekennzeichnet, daß fotoelektrische Mittel (30) vorhanden sind, deren Ausgangssignale zur Regelung der Fokussierung in der gemeinsamen Zwischenebene (10) benutzt werden.

9. Anordnung nach Anspruch 6, dadurch gekennzeichnet, daß ein optisch wirksames Mittel (31) zur Überwachung einer radialen Auswanderung der monochromatischen Strahlungsquellen (3, 4) vorgesehen ist.

10. Anordnung nach mindestens einem der Ansprüche 1 bis 9, dadurch gekennzeichnet, daß zwecks ihrer Verwendung als Prüfgerät für die Planität von Flächen zusätzlich ein Hilfshohlspiegel (42) sowie eine Blende (44) vorhanden sind (Fig. 3, 4).

11. Anordnung nach Anspruch 10, dadurch gekennzeichnet, daß ein Hilfsspiegel (43) eingesetzt werden kann, der die exakte Ermittlung der Ebenheit der im Meßgerät eingesetzten Planspiegel in eingebautem Zustand ermöglicht (Fig. 3, 4).

12. Anordnung nach mindestens einem der Ansprüche 1 bis 9, gekennzeichnet durch ihre Verwendung als Strukturbreitenmeßeinrichtung.

13. Anordnung nach mindestens einem der Ansprüche 1 bis 9, dadurch gekennzeichnet, daß zum Vergleichen zweier Objekte ein zweites abbildendes System (34, 40) mit fotoelektrischem Empfänger (41) vorgesehen ist, das zur Ermittlung der Lage der Objektkanten des Vergleichsobjektes dient (Fig. 2).

## Claims

1. Arrangement for the alignment, testing and/or measurement of two-dimensional objects disposed on a table (22), which is displaceable in at least two mutually perpendicular co-ordinate directions, of a measuring machine and determination of their coordinate position through scanning by means of a light spot for each co-ordinate direction, characterised by

(a) for each co-ordinate direction, an illumination equipment (1, 2), which consists of a radiation source (3, 4) with an optical element, with at least one radiation-collection system (7, 8) for the focussing of the light fluxes and with optical means (9) for guiding both the light fluxes together into a common ray path (11) and imaging of the radiation source (3, 4) in a common intermediate plane (10), wherein both light fluxes are provided at the same time with a certain identification,

(b) an optical component (13), which is variable in its position in only one direction, for redisposition of the light spots, which scan the object, along the respectively associated measurement co-ordinate direction,

(c) an in itself known measuring system, which is coupled with this component (13), for the detection of the respective redisposition,

(d) a beam-splitting optical member (16) for the deflection of the light fluxes according to their identification, wherein the imaging of one of the radiation sources is turned through 90° by means of a roof edge prism (15) in correspondence with the associated co-ordinate direction,

(e) an imaging system (21) for the imaging of both the produced light source images onto the respective object and by

(f) at least one photo-electric receiver system (28), which converts light fluxes, which are reflected from the respective object and result from the scanning of the same, into electrical measurement signals.

2. Arrangement for the alignment, testing and/or measurement of two-dimensional objects disposed on a table (22), which is displaceable in at least two mutually perpendicular co-ordinate directions, of a measuring machine and determination of their coordinate position through scanning by means of a light spot for each co-ordinate direction, characterised by

(a) a polarised radiation source with an illumination equipment with a Kerr cell which is connected therebehind and by means of which the direction of polarisation of the light is for identification varied in correspondence with the co-ordinate axes, with a least one radiation - collecting system for the imaging of the radiation source in an intermediate plane (10),

(b) an optical component (13), which is variable in its position in only one direction, for redisposition of the light spots, which scan the object, along the respectively associated measurement co-ordinate direction,

(c) an in itself known measuring system, which is coupled with this component (13), for the detection of the respective redisposition,

(d) beam-splitting optical member (16) for the deflection of the light fluxes according to their identification, wherein the imaging of the radiation source for a direction of polarisation is turned through 90° by means of a roof edge prism (15) in correspondence with the associated co-ordinate direction,

(e) an imaging system (21) for the imaging of both the produced light source images onto the respective object and by

(f) at least one photo-electric receiver system (28), which converts light fluxes, which are reflected from the respective object and result from the scanning of the same, into electrical measurement signals.

3. Arrangement according to claim 1 or 2, characterised thereby, that the imaging system (21) is associated with photo-electric transducer elements (26), the output signals of which, after having been processed in known manner into control signals, assure a constant focussed adjustment of the imaging system (21) onto the object.

4. Arrangement according to claim 1 or 2, characterised thereby, that optical means (23, 27) are provided, which permit a visual and/or television observation of the object and/or of the light spots.

5. Arrangement according to claim 1, characterised thereby, that the means indentifying the light fluxes produce differently polarised light fluxes.

6. Arrangement according to claim 1 or 2, characterised thereby, that in themselves known monochromatic radiation sources (3, 4) are provided.

7. Arrangement according to claim 1 or 2, characterised thereby, that the illumination equipment (1, 2) is designed in an in itself known manner for the production of collimated light fluxes.

8. Arrangement according to claim 1 or 2, characterised thereby, that photo-electric means (30) are present, the output signals of which are utilised for the regulation of the focussing in the common intermediate plane (10).

9. Arrangement according to claim 6, characterised thereby, that an optically effective means (31) is provided for the monitoring of a radial deviation of the monochromatic radiation sources (3, 4).

10. Arrangement according to at least one of the claims 1 to 9, characterised thereby, that for the purpose of its use as test instrument for the planarity of surfaces, an auxiliary hollow mirror (42) as well as a light stop (44) are present in addition (Figs. 3 and 4).

11. Arrangement according to claim 10, characterised thereby, that an auxiliary mirror (43) can be used, which makes the exact determination of the evenness of the planar mirrors, which are used in the measuring instrument, possible in the installed state (Figs. 3 and 4).

12. Arrangement according to at least one of the claims 1 to 9, characterised by its use as structure width measuring equipment.

13. Arrangement according to at least one of the claims 1 to 9, characterised thereby, that for the comparison of two objects, a second imaging system (34, 40) with photo-electric receiver (41) is provided and serves for the determination of the position of the object edges of the comparison object (Fig. 2).

**Revendications**

1. Agencement d'alignement, de contrôle et/ou de mesure d'objets bidimensionnels se trouvant sur une table (22) d'une machine de mesure déplaçable au moins dans deux directions de coordonnées s'étendant perpendiculairement l'une à l'autre et de détermination de leurs positions suivant les coordonnées par le repérage au moyen d'un spot lumineux par chaque direction de coordonnées, caractérisé par

(a)     pour chaque direction de coordonnées un dispositif d'éclairage (1, 2) se composant d'une source de rayonnement (3, 4) avec un élément optique et comprenant au moins un système collecteur de rayonnement (7, 8) pour focaliser les flux de lumière et des moyens optiques (9) pour réunir les deux flux de lumière en une marche de rayons commune (11) et pour une représentation des sources de rayonnement (3, 4) dans un plan intermédiaire commun (10), les deux flux de lumière étant dotés en même temps d'un moyen d'identification prédéterminé;

(b)     une pièce optique (13) dont la position n'est modifiable que dans une direction pour le déplacement des spots lumineux balayant l'objet le long de la direction de coordonnées de mesure respective qui leur est associée;

(c)     un système de mesure connu en soi relié à cette pièce (13) pour la détection du déplacement à chaque fois;

(d)     un organe optique diviseur de faisceau (16) pour la déviation des flux de lumière selon leurs moyens d'identification, en faisant tourner de 90° la représentation de l'une des sources de rayonnement suivant la direction de coordonnées qui lui est associée au moyen d'un prisme triangulaire (15);

(e)     un système de représentation ou projecteur (21) pour la représentation des deux images de source de rayonnement produites sur l'objet respectif, et par

(f)     au moins un système récepteur photo-électrique (28) qui transforme des flux de lumière réfléchis par l'objet respectif et résultant du repérage ou balayage de celui-ci en signaux de mesure électriques.

2. Agencement d'alignement, de contrôle et/ou de mesure d'objets bidimensionnels se trouvant sur une table (22) d'une machine de mesure déplaçable au moins dans deux directions de coordonnées perpendiculairement l'une à l'autre et de détermination de leurs positions selon les coordonnées par repérage au moyen d'un spot lumineux par direction de coordonnées, caractérisé par

(a)     une source de rayonnement polarisée avec un dispositif d'éclairage avec une cellule Kerr montée en aval au moyen de laquelle la direction de polarisation de la lumière pour l'identification est modifiée suivant les axes de coordonnées avec au moins un système collecteur de rayons pour la représentation de la source de rayonnement dans un plan intermédiaire (10);

(b)     une pièce optique (13) dont la position n'est modifiable que dans une direction pour le déplacement des spots lumineux repérant ou balayant l'objet le long de la direction respective de coordonnées de mesure qui leur est associée;

(c)     un système de mesure associé à cette pièce (13) et connu en soi pour la détermination du déplacement respectif;

(d)     un organe optique diviseur de rayons (16) pour la déviation de la lumière selon l'identification, la représentation de la source de rayonnement pour une direction de polarisation étant tournée de 90° suivant la direction de coordonnées y étant associée au moyen d'un prisme triangulaire (15);

(e)     un système de représentation (21) pour la représentation des deux images de source de lumière produites sur l'objet respectif et par

(f)     au moins un système récepteur photo-électrique (28) qui transforme la lumière réfléchie par l'objet respectif et résultant du balayage de celui-ci en signaux de mesure électriques.

3. Agencement selon la revendication 1 ou 2, caractérisé en ce qu'au système de représentation (21) sont associés des éléments convertisseurs photo-électriques (26) dont les signaux de sortie, convertis de manière connue en signaux de commande, garantissent une mise au point constante du sytème de représentation (21) sur l'objet.

4. Agencement selon la revendication 1 ou 2, caractérisé en ce que des moyens optiques (23, 37) sont prévus qui permettent une observation visuelle et/ou TV de l'objet et/ou des spots lumineux.

5. Agencement selon la revendication 1, caractérisé en ce que les moyens d'identification des flux de lumière produisent des flux de lumière polarisés différemment.

6. Agencement selon les revendications 1 ou 2, caractérisé en ce que des sources de rayonnement (3, 4) monochromatiques connues en soi sont prévues.

7. Agencement selon la revendication 1 ou 2, caractérisé en ce que, de manière connue en soi, le dispositif d'éclairage (1, 2) est adapté pour produire des flux de lumière focalisés.

8. Agencement selon les revendications 1 ou 2, caractérisé en ce qu'il est prévu des moyens photoélectriques (30) dont les signaux de sortie sont utilisés pour le réglage de la focalisation dans le plan intermédiaire commun (10).

9. Agencement selon la revendication 6, caractérisé en ce qu'un moyen optique efficace (31) est prévu pour la surveillance d'une déviation radiale des sources de lumière monochromatique (3, 4).

10. Agencement selon au moins l'une des revendications 1 à 9, caractérisé en ce que, en vue de leur utilisation comme appareil de vérification de la planéité de surfaces, il a été prévu en outre un miroir concave auxiliaire (42) ainsi qu'un diaphragme (44) (voir figures 3, 4).

11. Agencement selon la revendication 10, caractérisé en ce qu'un miroir auxiliaire (43) peut être inséré qui permet la détermination exacte de la planéité des miroirs plans utilisés dans l'appareil de mesure, à l'état monté (voir figures 3, 4).

12. Agencement selon au moins l'une des revendications 1 à 9, caractérisé par son utilisation comme dispositif de mesure de largeur de structure.

13. Agencement selon au moins l'une des revendications 1 à 9, caractérisé en ce que pour la comparaison de deux objets un deuxième système de représentation (34, 40) avec récepteur photo-électrique (41) est prévu qui sert à la détermination de la position des arêtes d'objet de l'objet de comparaison (voir figure 2).

EP 0 218 613 B1

Fig. 1

Fig. 2

1

# Fig. 3

Auflicht

# Fig. 4

Laser